# DEMANDE DE BREVET EUROPEEN

(11) **EP 2 605 349 A1**
(43) Date de publication de la demande: **19.06.2013**
(21) Numéro de dépôt: 12306304.2
(22) Date de dépôt: 22.10.2012
(51) Int. Cl.: H02B 1/01, H02B 13/02

(54) **Structure de support d'un appareil électrique de commande ou de protection électrique d'une cellule électrique moyenne tension**

(30) Priorité: 12.12.2011 FR 1103799
(71) Demandeur: Schneider Electric Industries SAS, 92500 Rueil-Malmaison (FR)
(72) Inventeur: Laye, Jérôme, 38050 GRENOBLE Cedex 09 (FR)
(74) Mandataire: Colette, Marie-Françoise

(57) **Abrégé**

La présente invention concerne une structure destinée à supporter la partie principale d'un appareil électrique de commande ou de protection électrique dans une cellule électrique moyenne tension, ladite structure étant posée sur une surface d'appui. Cette structure est caractérisée en ce qu'elle comporte deux flancs (6,7) sensiblement parallèles l'un par rapport à l'autre, chaque flanc comportant une partie dite principale (14,15) à partir de laquelle s'étend une partie formant aile (16,17), ces deux ailes étant destinées à être reliées l'une à l'autre au niveau de leur extrémité libre et au niveau de leur extrémité reliée à la partie principale des flancs par respectivement deux traverses (8,9) dites supérieures, les deux ailes comportant au niveau de leur jonction avec la partie principale des flancs, une ouverture (29,30) destinée à recevoir à coulissement respectivement les deux extrémités de l'une dite première (9) des traverses (8,9) dites supérieures, ladite structure comportant des moyens dits de butée et de verrouillage dits premiers pour empêcher le mouvement relatif de ladite traverse par rapport à la structure suivant cinq degrés de liberté sur six, le déplacement de la traverse selon le sixième degré de liberté correspondant à une translation dans un sens opposé au sens d'introduction des traverses, étant bloqué par des moyens de fixation, le seul montage de ladite traverse (9) dans lesdites ouvertures sans mise en oeuvre des moyens de fixation suffisant à rendre l'ensemble stable.

## Description

La présente invention concerne une structure destinée à supporter la partie principale d'un appareil électrique de commande ou de protection électrique dans une cellule électrique moyenne tension, ladite structure étant posée sur une surface d'appui.

On connaît de telles structures constituées principalement de montants, de traverses et de tôles d'habillage et dont le montage nécessite l'utilisation de table et de gabarit de montage.
En effet, les conceptions actuelles des équipements moyenne tension, est adaptée au mode de fabrication actuel, cette fabrication étant réalisée dans des unités d'équipement dédiées à ce montage, dans lesquelles des équipes spécialisées sont formées au produit et possèdent des outillages et des moyens pour réaliser le montage. Ce qui implique que le montage de telles structures peut difficilement être confié à des tableautiers extérieurs.

La présente invention résout ces problèmes et propose une structure de support d'un appareil électrique de commande ou de protection électrique d'une cellule électrique moyenne tension, de conception simple, comportant un nombre réduit de pièces, d'une grande facilité de montage car ne nécessitant que très peu d'outillage pour réaliser le montage et ne présentant qu'un nombre réduit de points d'assemblage.

A cet effet, la présente invention a pour objet une structure du genre précédemment mentionnée, cette structure étant **caractérisée en ce qu'**elle comporte deux flancs sensiblement parallèles l'un par rapport à l'autre, chaque flanc comportant une partie dite principale à partir de laquelle s'étend une partie formant aile, ces deux ailes étant destinées à être reliées l'une à l'autre au niveau de leur extrémité libre et au niveau de leur extrémité reliée à la partie principale des flancs par respectivement deux traverses dites supérieures, les deux ailes comportant au niveau de leur jonction avec la partie principale des flancs, une ouverture destinée à recevoir à coulissement respectivement les deux extrémités de l'une dite première des traverses dites supérieures, ladite structure comportant des moyens dits de butée et de verrouillage dits premiers pour empêcher le mouvement relatif de ladite traverse par rapport à la structure suivant cinq degrés de liberté sur six, le déplacement de la traverse selon le sixième degré de liberté correspondant à une translation dans un sens opposé au sens d'introduction des traverses, étant bloqué par des moyens de fixation, le seul montage de ladite traverse dans lesdites ouvertures sans mise en oeuvre des moyens de fixation suffisant à rendre l'ensemble stable.

Selon une caractéristique particulière, la traverse supérieure dite première est introduite dans lesdites ouvertures par coulissement suivant une direction sensiblement perpendiculaire au plan de la surface d'appui.

Selon une autre caractéristique, cette structure comporte une seconde traverse dite supérieure apte à être montée de la même manière que la première dans deux ouvertures prévues respectivement aux deux extrémités libres respectivement des deux ailes.

Selon une autre caractéristique, chacune des ailes précitées comporte une ouverture de forme sensiblement rectangulaire délimitée par deux longerons respectivement un longeron supérieur et un longeron inférieur, lesdits longerons s'étendant sensiblement parallèlement à la surface d'appui et les deux longerons de chaque flanc étant reliés l'un à l'autre au niveau de leur extrémité libre par un montant vertical venu de matière avec le flanc correspondant, ladite structure comportant deux autres traverses dites inférieures aptes à relier les deux longerons inférieurs des deux flancs au niveau de leur extrémité par laquelle ils sont reliés au flanc correspondant, et au niveau de leur extrémité libre.

Selon une autre caractéristique, les deux traverses inférieures sont montées dans ladite structure suivant deux mouvements successifs respectivement un mouvement de translation selon une direction inclinée par rapport à la surface d'appui suivi d'un mouvement de rotation par rapport à un axe s'étendant parallèlement à la largeur de la structure en direction des flancs, après quoi le déplacement des traverses dites inférieures par rapport à la structure suivant les cinq degrés de liberté est empêché par des moyens de butée et de verrouillage dits seconds prévus sur les flancs coopérant avec les traverses dites inférieures, le déplacement relatif des traverses inférieures par rapport aux flancs suivant le sixième degré de liberté étant bloqué par des moyens de fixation.

Selon une autre caractéristique, chacune des traverses comporte une paroi de fond, un premier rebord longitudinal plié à angle droit, un second rebord longitudinal plié deux fois à angle droit, un premier rebord latéral plié à angle droit, un second rebord latéral plié à angle droit, ledit premier rebord longitudinal comportant de chaque côté de la traverse, une encoche dite première s'étendant parallèlement à la profondeur de la traverse, tandis que les rebords latéraux comportent chacun à leur extrémité libre reliée au rebord longitudinal dit second, une encoche dite seconde.

Selon une autre caractéristique, en position montée des traverses supérieures, le déplacement vers le bas des traverses supérieure est bloqué par l'intermédiaire d'une part, des encoches dites secondes coopérant chacune avec un bord plié à angle droit du flanc correspondant, et d'autre part, à chaque extrémité des traverses, d'une partie du rebord longitudinal dit premier de la traverse coopérant respectivement avec une face horizontale appartenant au longeron correspondant.

Selon une autre caractéristique, en position montée des traverses supérieures, le déplacement latéral des traverses supérieures est bloqué d'une part par l'intermédiaire des deux rebords latéraux de chaque traverse coopérant avec respectivement avec deux faces verticales des deux flancs et d'autre part, par l'intermédiaire des deux encoches dites premières de chaque traverse coopérant respectivement avec deux bords pliés à angle droit formant nervure appartenant respectivement aux deux longerons supérieurs.

Selon une autre caractéristique, en position montée des traverses supérieures, le déplacement des traverses supérieures suivant la direction longitudinale de la structure est bloqué par premièrement, à chacune des extrémités de chaque traverse, la mise en butée d'une partie du bord libre du rebord longitudinal dit premier avec une partie d'extrémité d'une face horizontale appartenant au longeron correspondant, deuxièmement, de parties pliées en équerre des flancs coopérant avec la face extérieure de la paroi de fond des traverses, et troisièmement, par l'intermédiaire des encoches dites premières coopérant avec les bords des longerons formant nervure..

Selon une autre caractéristique, lors du montage des traverses inférieures, les deux encoches dites premières de chaque traverse inférieure coopèrent respectivement avec deux bords pliés à angle droit formant nervure appartenant respectivement aux deux longerons dits inférieurs de manière à guider lesdites traverses inférieures en rotation en direction des flancs par rapport à un axe passant par les points de contact entre l'extrémité desdits bords et respectivement les deux encoches, jusqu'à la mise en contact du rebord longitudinal dit second 26 de la traverse inférieure avec deux bords pliés en équerre 44,62 appartenant respectivement aux deux flancs.

Selon une autre caractéristique, en position montée des traverses inférieures, le déplacement en hauteur des traverses est empêché par d'une part, l'amenée en appui du rebord longitudinal dit premier de chaque traverse inférieure sur deux faces horizontales appartenant respectivement aux deux longerons inférieurs et d'autre part, l'encliquetage des encoches dites secondes dans des encoches correspondantes formées à l'extrémité des bords pliés à angle droit des flancs.

Selon une autre caractéristique, le déplacement des traverses inférieures selon la direction longitudinale de la structure est bloqué par premièrement, l'amenée en contact de l'extrémité de deux rebords pliés en équerre appartenant respectivement aux deux longerons inférieurs avec respectivement le bord longitudinal libre des deux rebords latéraux de chaque traverse, deuxièmement, par des parties pliées à angle droit appartenant aux deux flancs amenées en contact avec la face arrière de la paroi de fond des traverses et troisièmement par les encoches dites premières coopérant avec les parties formant nervures des longerons inférieurs.

Selon une autre caractéristique, le déplacement des traverses inférieures suivant la largeur de la structure est bloqué par d'une part, la mise en contact des deux rebords latéraux de chaque traverse avec respectivement deux faces intérieures appartenant respectivement aux deux longerons dits inférieurs, et d'autre part par les encoches dites premières coopérant avec les parties formant nervures des longerons inférieurs.

Selon une autre caractéristique, les rebords longitudinaux dits seconds sont fixés aux flancs, au niveau de chacune des extrémités des traverses par l'intermédiaire de rivets.

Selon une autre caractéristique, cette structure est destinée à loger, entre les deux parties pleines des flancs, une boîte à câbles, en ce que la partie située entre les deux parties comportant une ouverture de forme sensiblement rectangulaire est destinée à permettre l'évacuation des gaz en cas d'arc interne, en ce qu'au-dessus de cette dernière partie est posée la partie principale de l'appareil, et en ce qu'au-dessus de cette boîte à câbles se trouve un compartiment destiné à loger la partie permettant la commande de l'appareil.

Mais d'autres avantages et caractéristiques de l'invention apparaîtront mieux dans la description détaillée qui suit et se réfère aux dessins annexés donnés uniquement à titre d'exemple et dans lesquels :
- La figure 1 est une vue en perspective illustrant une cellule moyenne tension supportée par une structure selon une réalisation particulière de l'invention,
- La figure 2 est une vue en perspective illustrant la structure seule,
- La figure 3 est une vue en perspective illustrant la partie intérieure d'une traverse selon l'invention,
- La figure 4 est une vue identique à la précédente, en position inversée de la traverse,
- La figure 5 est une vue de côté d'un des deux flancs de la structure, illustrant sa face extérieure,
- La figure 6 est une vue de côté d'un des deux flancs illustrant sa face intérieure,
- Les figures 7,8 9 et 10 illustrent en perspective quatre étapes de montage permettant le montage des deux traverses supérieures de la structure,

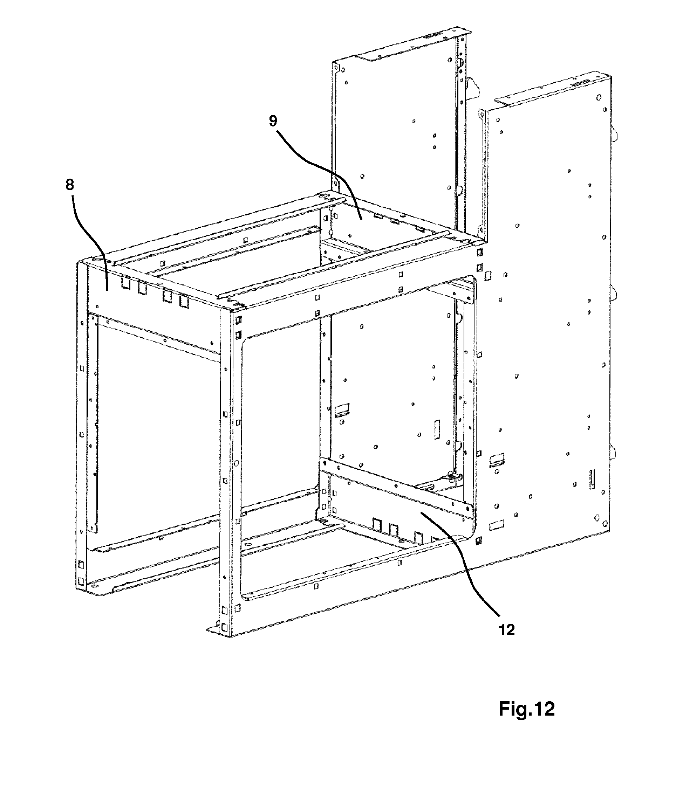

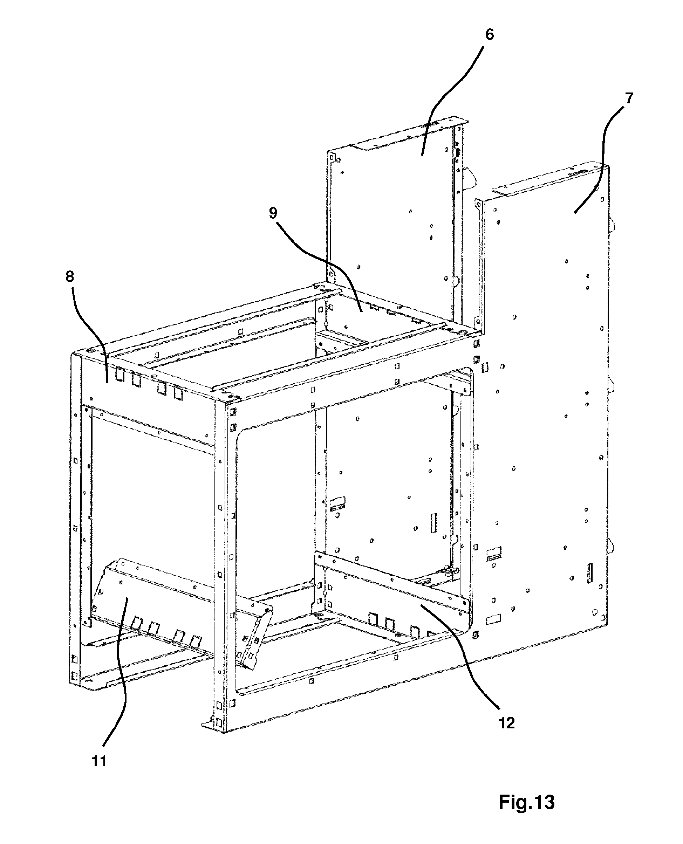

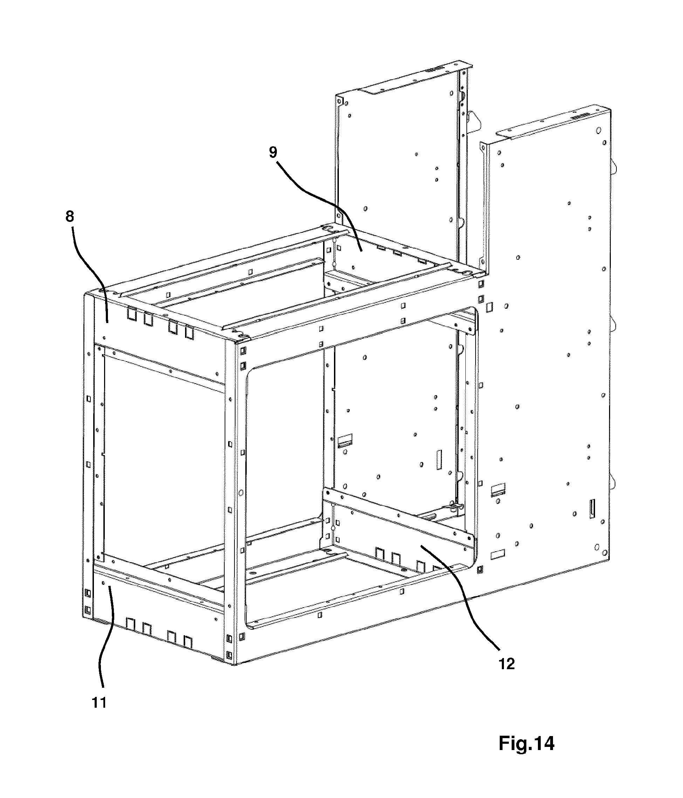

- Les figures 11, 12, 13 et 14 illustrent quatre étapes de montage permettant le montage de deux traverses inférieures,
- La figure 15 est une vue de détail illustrant en perspective l'une des extrémités d'une traverse dite supérieure en position montée sur les flancs,
- La figure 16 est une vue arrière de la figure précédente,
- La figure 17 est une vue de détail illustrant en perspective l'une des extrémités d'une traverse inférieure en position montée sur les flancs,
- La figure 18 est une vue arrière de la figure précédente,

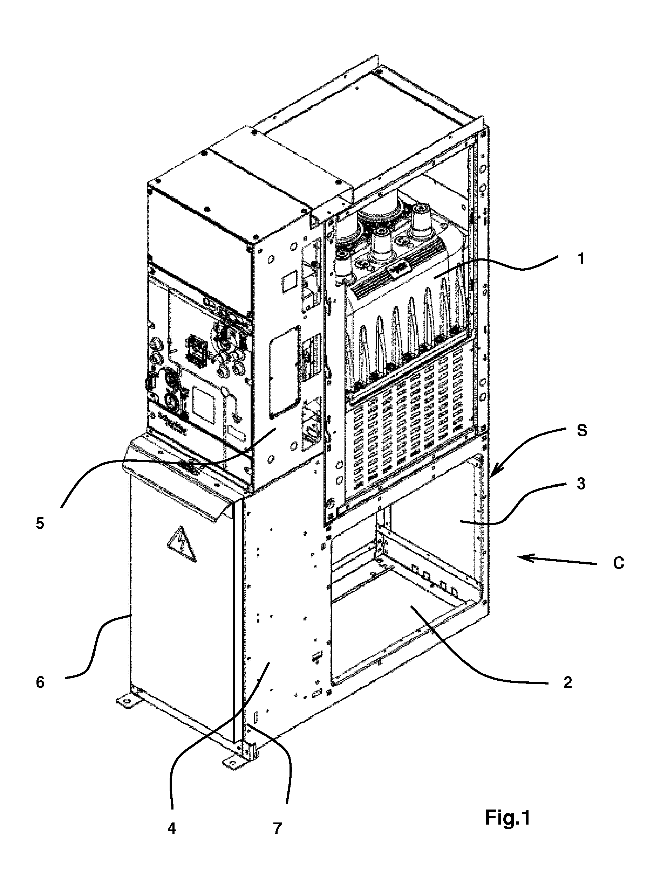

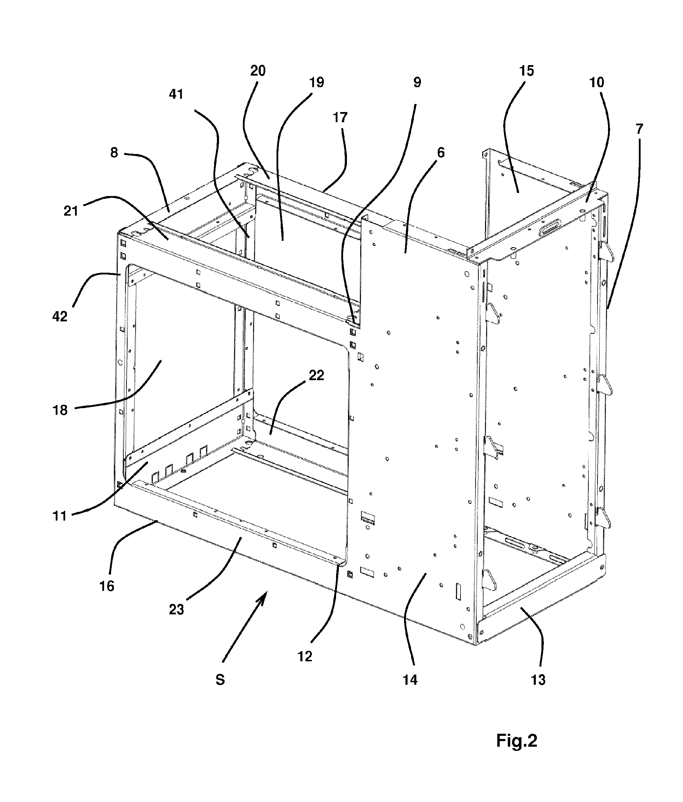

Sur la figure 1, on voit une cellule électrique moyenne tension C montée dans une structure S selon l'invention, ladite structure étant illustrée séparément sur la figure 2, l'ensemble en position montée étant en appui sur le sol. Cette structure S comporte une partie surélevée par rapport au sol formant une surface d'appui sur laquelle est posée la partie principale de l'appareil 1. Le compartiment 2 situé sous cette partie principale de l'appareil comporte un espace vide 3 destiné à permettre l'évacuation des gaz en cas d'arc interne. Cet ensemble comporte également sur le côté de ce compartiment vide 2 un compartiment fermé 4 constituant une boîte à câbles, au-dessus de laquelle est placée une partie 5 destinée à loger les moyens de commande de l'appareil.

Tel qu'illustré sur la figure 2, la structure selon l'invention comporte deux flancs 6,7 parallèles l'un par rapport à l'autre, ces deux flancs étant reliés l'un à l'autre par des traverses 8, 9,10,11,12,13. Chacun des deux flancs comporte une partie pleine 14,15 de forme sensiblement rectangulaire à partir de laquelle s'étendent respectivement deux ailes 16,17 comportant chacune une ouverture rectangulaire 18,19 délimitée chacune par deux longerons horizontaux 20,22 et 21,23 reliés par l'une de leurs extrémités à la partie pleine du flanc correspondant, les deux longerons d'un même flanc étant reliés l'un à l'autre à leur extrémité libre par un montant 41,42.

Ces deux flancs sont reliés l'un à l'autre par trois traverses dites supérieures 8,9,10, respectivement une traverses supérieure 9 dite première reliant les longerons dits supérieures au niveau de leur liaison avec les parties pleines des flancs, une traverse supérieure dite seconde 8 reliant les extrémités libres des longerons, et une traverse supérieure dite troisième 10 reliant les coins extérieurs des parties pleines des flancs.

Ces deux flancs sont reliés également par trois traverses dites inférieures 11,12,13 comprenant respectivement une traverse inférieure dite première 12 reliant les deux longerons horizontaux au niveau de leur jonction avec les parties pleines des flancs, une traverse inférieure dite seconde 11 reliant ces deux longerons au niveau de leur extrémité libre, et une traverse inférieure dite troisième 13 reliant les deux coins inférieurs des flancs.

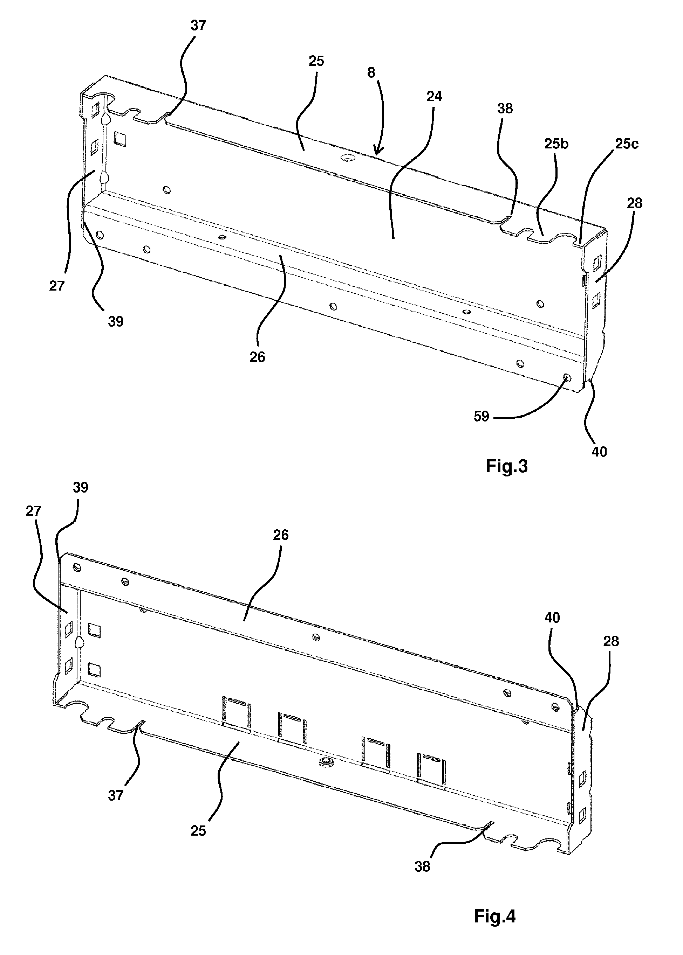

Les figures 3 et 4 illustrent une traverse 8 pouvant être utilisée aussi bien comme traverse supérieure que comme traverse inférieure, ladite traverse comportant une paroi de fond 24 et quatre rebords, respectivement un rebord longitudinal dit premier 25 plié une fois en équerre, un rebord longitudinal dit second 26 plié deux fois en équerre, un premier rebord latéral 27 plié en équerre et un second rebord latéral 28 plié en équerre.

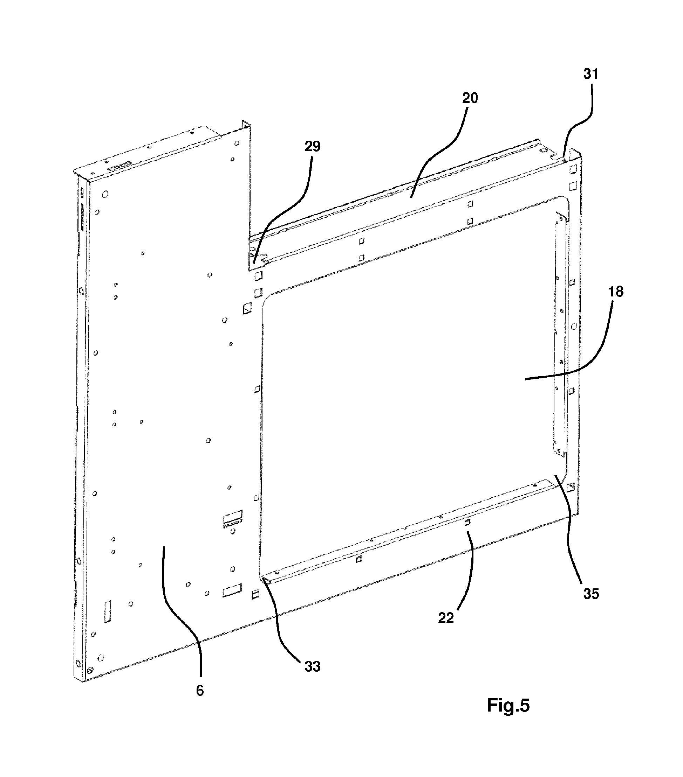

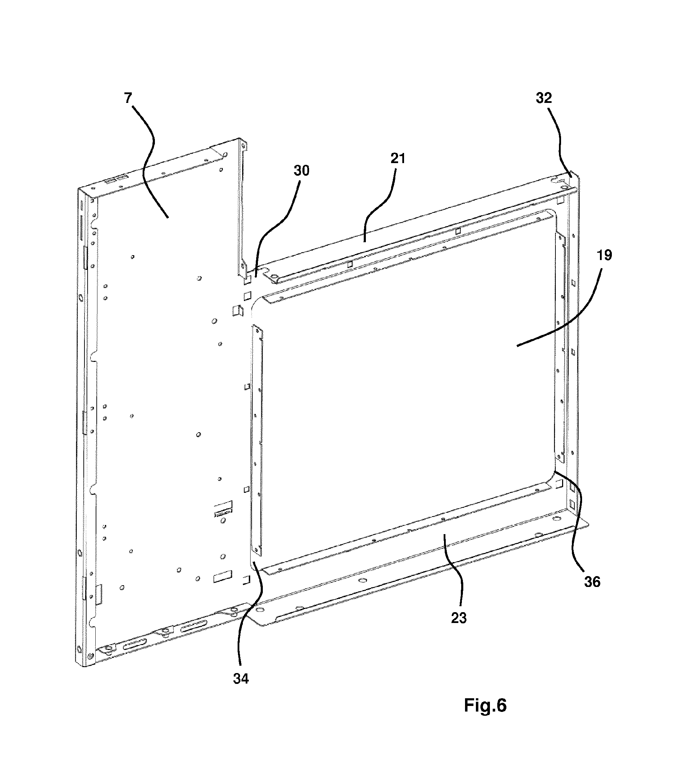

Ces traverses sont destinées à être introduites dans des évidements 29,30,31,32 et 33,34,35,36 (fig.5 et fig.6) prévus à cet effet dans les longerons et fixées par rapport à ces longerons par des moyens de butée, de verrouillage et de fixation prévus en partie sur les traverses et en partie sur les longerons.

Ces moyens de butée et de verrouillage sont destinés à empêcher le mouvement relatif des traverses dites supérieures et inférieures par rapport aux longerons dits supérieurs et inférieurs selon cinq degrés de liberté de mouvement, tandis que le mouvement relatif suivant le dernier degré de liberté restant est bloqué par rivetage ou vissage des traverses sur les flancs.

Ainsi, le premier rebord longitudinal 25 comporte à chaque extrémité de chaque traverse, une encoche dite première 37,38 s'étendant parallèlement à la profondeur de la traverse, tandis que les rebords latéraux 27,28 comportent chacun à leur extrémité libre reliée au rebord longitudinal dit second 26, une encoche dite seconde 39,40 s'étendant suivant la direction longitudinale desdits rebords latéraux et constituant une partie des moyens de butée et de verrouillage précités.

Le montage de la structure telle que décrite précédemment va être décrit dans ce qui suit en référence aux figures.

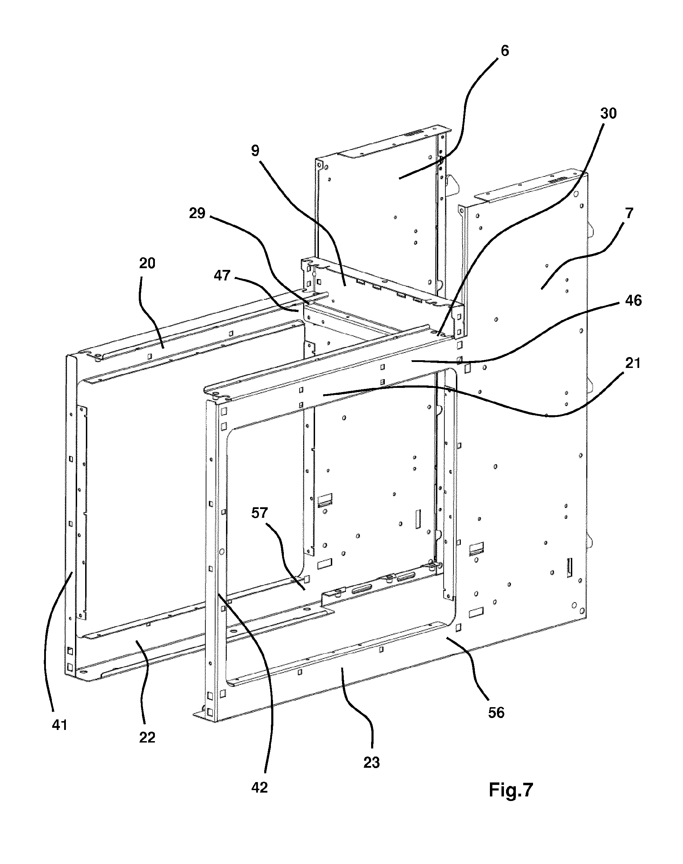

Sur la figure 7, l'on procède à l'introduction d'une traverse supérieure dite première 9 dans les évidements 29,30 prévus à cet effet dans les traverses supérieures 20,21, cette introduction étant réalisée suivant une direction sensiblement perpendiculaire à la surface d'appui de la cellule.

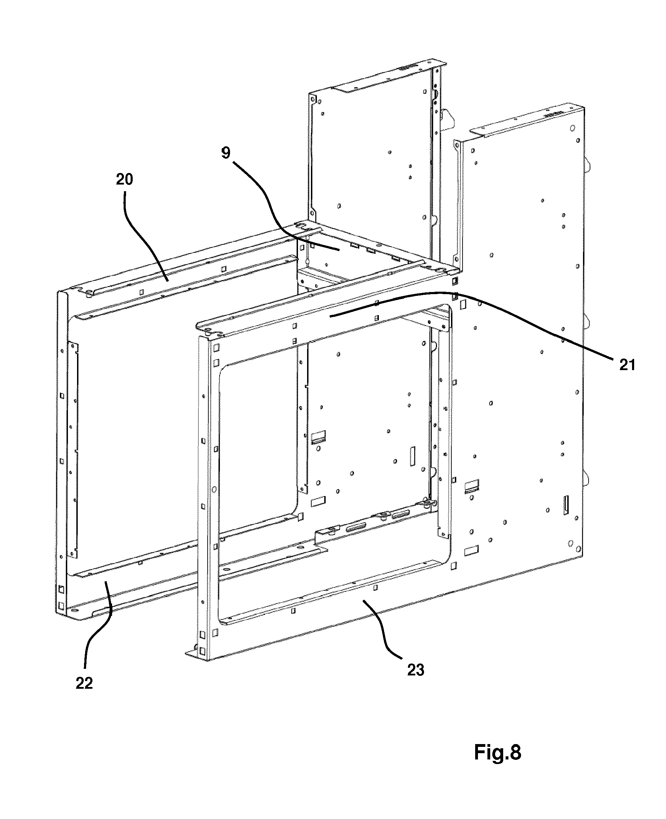

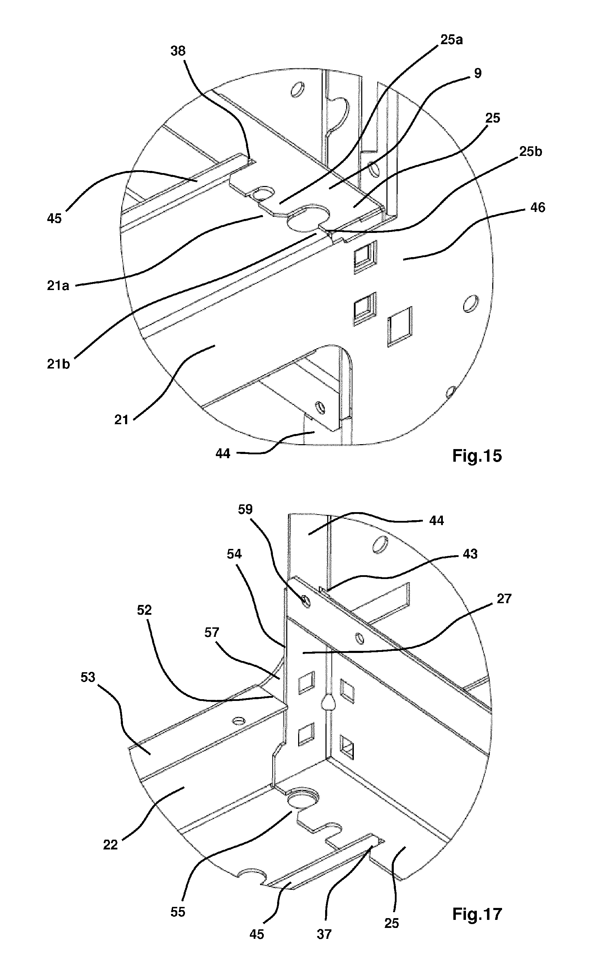

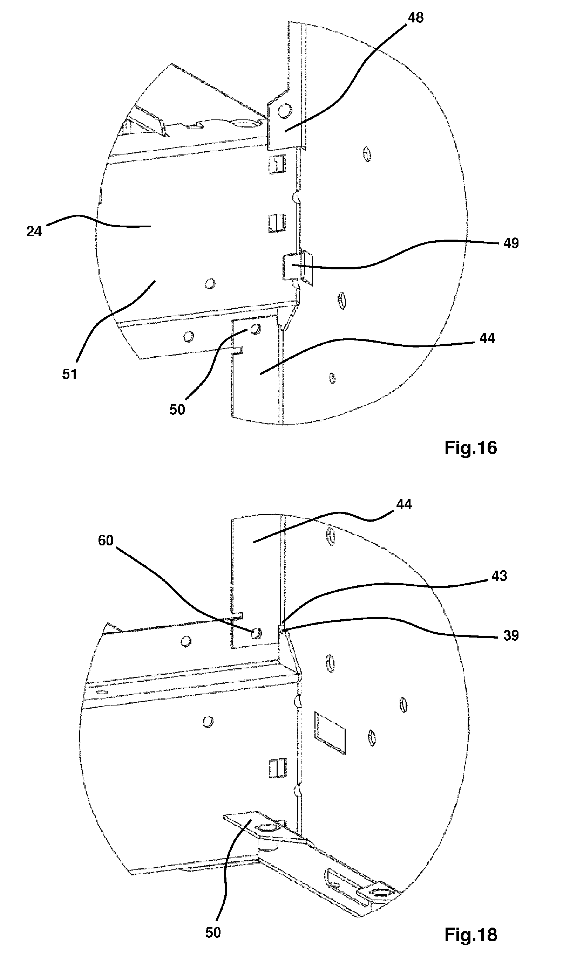

Sur la figure 8, et tel que particulièrement illustré sur les figures 15 et 16, cette traverse 9 est en position montée dans la structure. A la fin de cette introduction, le déplacement de la traverse est arrêté, aux deux extrémités de la traverse, par la coopération entre une partie 25a du premier rebord longitudinal 25 plié à 90°de la traverse avec une face 21a appartenant au longeron 21 correspondant et s'étendant parallèlement à la surface d'appui, et d'autre part la coopération entre l'encoche dite seconde 39,40 prévue à l'extrémité de chaque rebord latéral 27 de la traverse avec une encoche 43 de forme correspondante prévue à une extrémité libre d'un rebord 44 plié à angle droit du flanc.

Dans cette position, le déplacement de la traverse parallèlement à la direction transversale de la structure, c'est-à-dire suivant sa largeur, est empêché par d'une part, de chaque côté de la traverse, la coopération entre l' encoche dite première 37,38 prévue dans le premier rebord longitudinal plié en équerre 25 de la traverse coopérant avec une partie formant nervure 45 du longeron formée par un pli à 90° de celui-ci, et d'autre part, par l'amenée en contact des rebords latéraux 27,28 de la traverse avec une face intérieure 46,47 du longeron correspondant.

Le déplacement de la traverse suivant la direction longitudinale de la structure est empêché par d'une part, des parties pliées à angle droit 48,49,50 appartenant aux flancs coopérant avec la face extérieure 51 de la paroi de fond 24 de la traverse, d'autre part, la nervure précitée 45 du longeron coopérant avec l'encoche dite première 37,38 et enfin à chacune des extrémités de chaque traverse, par la mise en butée d'une partie 25b du bord libre du rebord longitudinal dit premier 25 avec une partie d'extrémité 21 b d'une face horizontale 21 a appartenant au longeron correspondant (21).

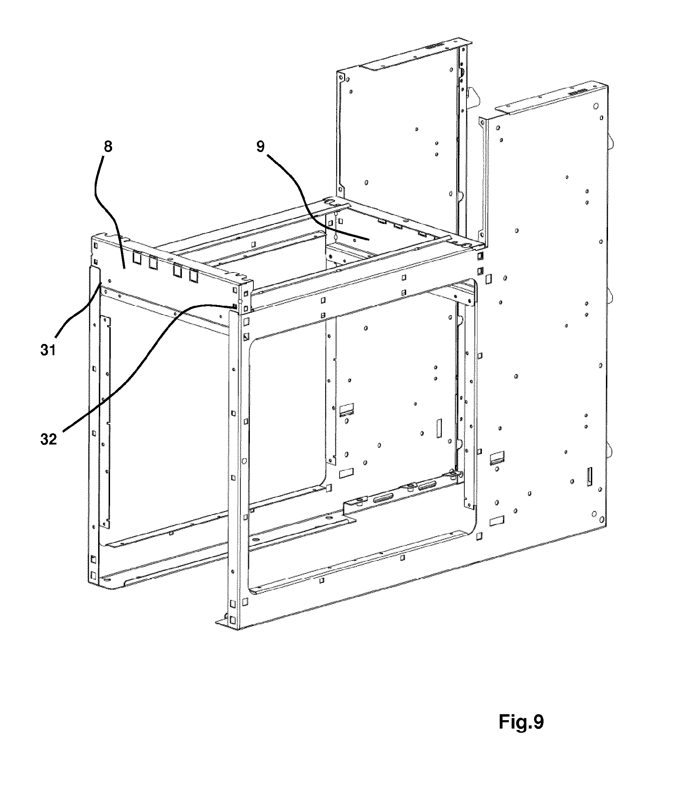

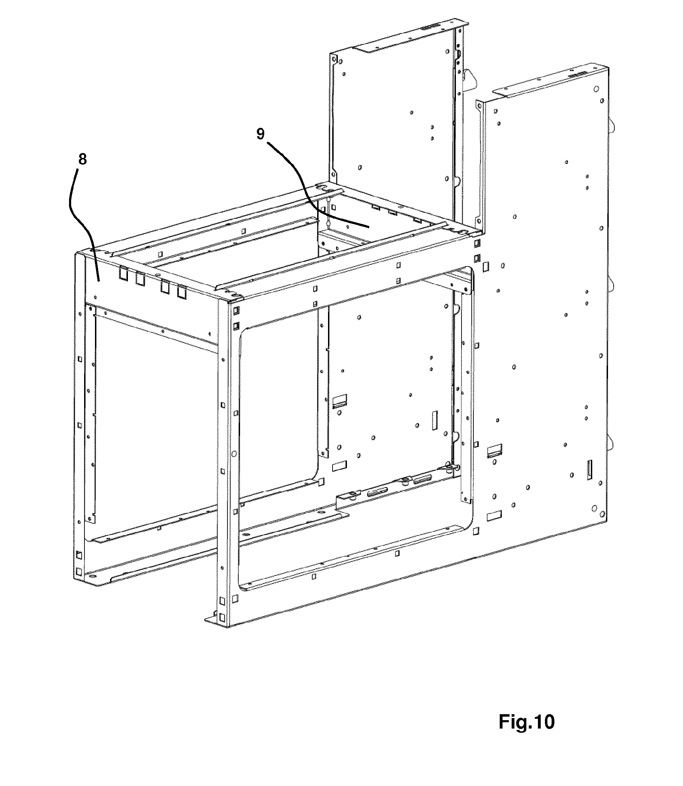

Sur la figure 9, une même traverse 8 est introduite dans deux évidements 31,32 prévus à l'extrémité libre des longerons supérieurs de la même manière que pour le premier longeron, cette traverse étant en position montée sur la figure 10.

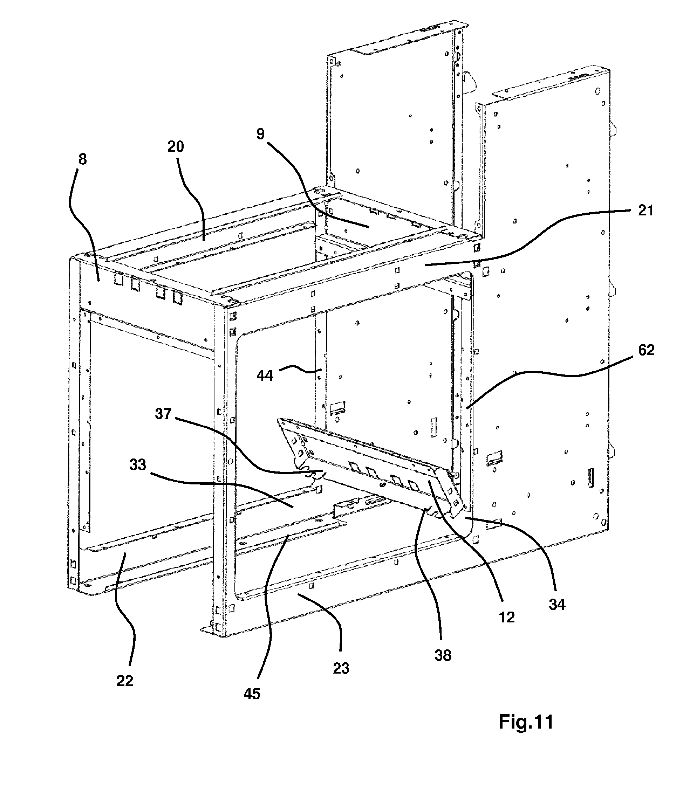

Sur la figure 11, l'on effectue le montage d'une première traverse 12 dite inférieure dans un évidement 33,34 prévu à cet effet dans les longerons inférieurs 22,23. Pour se faire, la traverse 12 est tout d'abord introduite dans les évidements par translation suivant une direction inclinée de sensiblement 45 ° par rapport à la surface d'appui, puis les encoches dites premières 37,38 prévues dans le premier rebord longitudinal 25 sont amenées à coopérer avec des nervures correspondantes 45 formées par des bords pliés à 90° des longerons inférieurs 22,23, après quoi la traverse 12 est entraînée en rotation en direction des flancs par rotation de la traverse autour de deux points de rotation constitués par les points de contact entre le fond des encoches dites premières 37,38 et l'extrémité des nervures 45. A la fin de cette rotation, les encoches dites secondes 39,40 formées à l'extrémité libre des premier et second rebords latéraux 27,28 pliés en équerre coopèrent respectivement avec les extrémités 43 des rebords pliés en équerre 44 des deux flancs de manière à réaliser un verrouillage par encliquetage de cette traverse sur ces parties de flanc (fig.17 et fig.18).

Ainsi, de la même manière que lors du montage des traverses supérieures, et tel qu'illustré sur les figures 17 et 18, le déplacement des traverses inférieures 11,12 suivant la longueur de la structure est empêché par coopération entre d'une part, un bord plié en équerre formant nervure 45 des longerons 22,23 avec les encoches dites premières 37,38 des traverses, d'autre part, des parties pliées à angle droit 48,49,50 des flancs venant en appui contre la face arrière 51 de la paroi de fond 24 de la traverse, ainsi que l'amenée en appui d'un bord libre 52 d'un rebord plié à angle droit 53 des longerons sur le bord longitudinal libre 54 des rebords latéraux 27,28.

Le déplacement de la traverse suivant la hauteur de la structure est empêché par d'une part, la mise en appui du premier rebord longitudinal 25 de la traverse sur une face horizontale 55 du longeron 22 et l' encliquetage de la traverse tel que précédemment décrit.

Le blocage du mouvement de la traverse suivant sa largeur s'effectue d'une part par l'intermédiaire des encoches dites premières 37,38 coopérant avec les nervures 45 et d'autre part la mise en contact des rebords latéraux 28,29 des traverses avec les faces latérales 56,57 correspondantes des longerons inférieures.

On effectue le montage de la seconde traverse inférieure de la même manière que précédemment.

La fixation définitive est réalisée au moyen de rivets (non représentés), huit au total pour les quatre traverses, à travers d'orifices 59 prévus aux extrémités des rebords longitudinaux dits seconds 26 des traverses coopérant avec des orifices 60 prévues en regard dans les parties pliées à angle droit 44, 62 des parties pleines des flancs (fig.11, fig.17 et fig.18).

On notera que la fixation définitive pourra être réalisée au moyen d'autres sortes de moyens de fixation dont des vis et des écrous, etc...

On a donc réalisé selon l'invention une structure qui permet une fois assemblée de recevoir la partie principale de la cellule, cette structure étant de conception simple, car présentant un nombre de pièces réduit puisque seuls deux flancs et un seul type de traverse est nécessaire. Cette structure présente en outre une grande facilité de montage et une bonne ergonomie ainsi qu'un nombre réduit de points d'assemblage afin de réaliser le produit.

En effet, pendant la phase de montage, l'opérateur est aidé par le fait que la structure est un sous ensemble stable alors que toutes les pièces ne sont pas montées. En effet, cet ensemble est stable alors qu'il n'y a qu'une traverse supérieure qui est montée sans mise en oeuvre de points de fixation.

Le montage des traverses supérieures s'effectue par un mouvement unique vertical du haut vers le bas. La traverse n'a qu'une seule position possible grâce au détrompage réalisé par les encoches dites premières.

Le montage des traverses inférieures s'effectue par un mouvement combiné de translation suivi d'un mouvement de rotation. La traverse n'a qu'une seule position possible, grâce au système de détrompage constitué par les encoches dites premières coopérant avec les parties des longerons formant nervure.

Une fois en position, la stabilité de la structure est assurée par la maitrise des positions des traverses. Les moyens de butées et verrouillage permettent de bloquer cinq ou six degrés de liberté possibles. Le dernier mouvement est bloqué par les points de fixation.

Ainsi, ces formes combinées entre les flancs et les traverses permettent un bon encastrement qui assure la fonction « d'auto-portance » lorsque les flancs plus une traverse sont assemblés et posés sur le sol subissant l'effet de la gravité. Ainsi, sont supprimés des degrés de liberté de mouvement relatif, ce qui maintient l'assemblage en place.

Le monteur n'a plus besoin de table ou de gabarit de montage, et l'assemblage s'en trouve grandement simplifié car plus simple et rapide.

Bien entendu l'invention n'est pas limitée au mode de réalisation décrit et illustré qui n'a été donné qu'à titre d'exemple.

Au contraire, l'invention comprend tous les équivalents techniques des moyens décrits ainsi que leurs combinaisons si celles-ci sont réalisées suivant son esprit.

## Revendications

1. Structure destinée à supporter la partie principale d'un appareil électrique de commande ou de protection électrique dans une cellule électrique moyenne tension, ladite structure étant posée sur une surface d'appui,
**caractérisée en ce qu'**elle comporte deux flancs (6,7) sensiblement parallèles l'un par rapport à l'autre, chaque flanc comportant une partie dite principale (14,15) à partir de laquelle s'étend une partie formant aile (16,17), ces deux ailes étant destinées à être reliées l'une à l'autre au niveau de leur extrémité libre et au niveau de leur extrémité reliée à la partie principale des flancs par respectivement deux traverses (8,9) dites supérieures, les deux ailes comportant au niveau de leur jonction avec la partie principale des flancs, une ouverture (29,30) destinée à recevoir à coulissement respectivement les deux extrémités de l'une dite première (9) des traverses (8,9) dites supérieures, ladite structure comportant des moyens dits de butée et de verrouillage dits premiers portés en partie par la traverse et en partie par les flancs, pour empêcher le mouvement relatif de ladite traverse par rapport à la structure suivant cinq degrés de liberté sur six, le déplacement autorisé de la traverse selon le sixième degré de liberté correspondant à une translation dans un sens opposé au sens d'introduction des traverses étant destiné à être bloqué par des moyens de fixation (59,60) portés en partie par la traverse et en partie par les flancs, de telle manière que le seul montage de ladite traverse (9) dans lesdites ouvertures (29,30) avant la mise en oeuvre des moyens de fixation suffise à rendre l'ensemble constitué par les flancs et une seule traverse stable, sous l'effet de la gravité.

2. Structure selon la revendication 1, **caractérisée en ce que** la traverse supérieure (9) dite première est introduite dans lesdites ouvertures (29,30) par coulissement suivant une direction sensiblement perpendiculaire au plan de la surface d'appui.

3. Structure selon la revendication 1 ou 2, **caractérisée en ce qu'**elle comporte une seconde traverse dite supérieure (8) apte à être montée de la même manière que la première dans deux ouvertures (31,32) prévues respectivement aux deux extrémités libres respectivement des deux ailes.

4. Structure selon l'une quelconque des revendications 1 à 3, **caractérisée en ce que** chacune des ailes précitées (16,17) comporte une ouverture de forme sensiblement rectangulaire (18,19) délimitée par deux longerons respectivement un longeron supérieur (20,21) et un longeron inférieur (22,23), lesdits longerons s'étendant sensiblement parallèlement à la surface d'appui et les deux longerons de chaque flanc étant reliés l'un à l'autre au niveau de leur extrémité libre par un montant vertical (41,42) venu de matière avec le flanc correspondant, ladite structure comportant deux autres traverses dites inférieures (11,12) aptes à relier les deux longerons inférieurs des deux flancs au niveau de leur extrémité par laquelle ils sont reliés au flanc correspondant, et au niveau de leur extrémité libre.

5. Structure selon la revendication 4, **caractérisée en ce que** les deux traverses inférieures (11,12) sont montées dans ladite structure suivant deux mouvements successifs respectivement un mouvement de translation selon une direction inclinée par rapport à la surface d'appui, suivi d'un mouvement de rotation par rapport à un axe s'étendant parallèlement à la largeur de la structure, en direction des flancs, après quoi le déplacement des traverses dites inférieures par rapport à la structure suivant les cinq degrés de liberté est empêché par des moyens de butée et de verrouillage dits seconds prévus sur les flancs coopérant avec les traverses dites inférieures (11,12), le déplacement relatif des traverses inférieures par rapport aux flancs suivant le sixième degré de liberté étant bloqué par des moyens de fixation.

6. Structure selon l'une quelconque des revendications précédentes, **caractérisée en ce que** chacune des traverses (8 à 11) comporte une paroi de fond (24), un premier rebord longitudinal (25) plié à angle droit, un second rebord longitudinal (26) plié deux fois à angle droit, un premier rebord latéral (27) plié à angle droit, un second rebord latéral (28) plié à angle droit, ledit premier rebord longitudinal (25) comportant de chaque côté de la traverse, une encoche dite première (37,38) s'étendant parallèlement à la profondeur de la traverse, tandis que les rebords latéraux (27,28) comportent chacun à leur extrémité libre reliée au rebord longitudinal dit second (26), une encoche dite seconde (39,40).

7. Structure selon la revendication 6, **caractérisée en ce qu'**en position montée des traverses supérieures, le déplacement vers le bas des traverses supérieures (8,9) est bloqué par l'intermédiaire d'une part, des encoches dites secondes (39,40) coopérant chacune avec un bord plié à angle droit (44) du flanc correspondant, et d'autre part, à chaque extrémité des traverses, d'une partie (25a) du rebord longitudinal dit premier (25) de la traverse coopérant respectivement avec une face horizontale (21 a) appartenant au longeron correspondant (21).

8. Structure selon la revendication 6 ou 7, **caractérisée en ce qu'**en position montée des traverses supérieures (8,9), le déplacement latéral des traverses supérieures est bloqué d'une part par l'intermédiaire des deux rebords latéraux (27,28) de chaque traverse coopérant avec respectivement deux faces verticales (46,47) des deux flancs et d'autre part, par l'intermédiaire des deux encoches dites premières (37,38) de chaque traverse coopérant respectivement avec deux bords pliés à angle droit formant nervure (45) appartenant respectivement aux deux longerons supérieurs (20,21).

9. Structure selon l'une quelconque des revendications 6,7 ou 8 **caractérisée en ce qu'**en position montée des traverses supérieures, le déplacement des traverses supérieures (8,9) suivant la direction longitudinale de la structure est bloqué par premièrement, à chacune des extrémités de chaque traverse, la mise en butée d'une partie (25b) du bord libre du rebord longitudinal dit premier (25) avec une partie d'extrémité (21 b) d'une face horizontale (21 a) appartenant au longeron correspondant (21), deuxièmement, de parties pliées en équerre des flancs (48,49,50) coopérant avec la face extérieure (51) de la paroi de fond (24) des traverses, et troisièmement par l'intermédiaire des encoches dites premières (37,38) coopérant avec les bords des longerons formant nervure (45).

10. Structure selon la revendication 5 et l'une quelconque des revendications 6 à 9, **caractérisé en ce que** lors du montage des traverses inférieures (11,12), les deux encoches dites premières (37,38) de chaque traverse inférieure coopère respectivement avec deux bords pliés à angle droit formant nervure (45) appartenant respectivement aux deux longerons dits inférieurs de manière à guider lesdites traverses inférieures en rotation en direction des flancs par rapport à un axe passant par les points de contact entre l'extrémité desdits bords (45) et respectivement les deux encoches, jusqu'à la mise en contact du rebord longitudinal dit second (26) de la traverse inférieure avec deux bords pliés en équerre (44,62) appartenant respectivement aux deux flancs.

11. Structure selon la revendication 10, **caractérisée en ce qu'**en position montée des traverses inférieures (11,12), le déplacement en hauteur des traverses est empêché par d'une part, l'amenée en appui du rebord longitudinal dit premier (25) de chaque traverse inférieure sur deux faces horizontales (55) appartenant respectivement aux deux longerons inférieurs (22,23) et d'autre part, l'encliquetage des encoches dites secondes (39 ,40) dans des encoches correspondantes (43) formées à l'extrémité des bords pliés à angle droit (44,62) des flancs.

12. Structure selon la revendication 10 ou 11, **caractérisée en ce que** le déplacement des traverses inférieures (11,12) selon la direction longitudinale de la structure est bloqué par premièrement, l'amenée en contact de l'extrémité (52) de deux rebords (53) pliés en équerre appartenant respectivement aux deux longerons inférieurs (22,23) avec respectivement le bord longitudinal libre (54) des deux rebords latéraux (27,28) de chaque traverse, et deuxièmement, par des parties pliées à angle droit (48,49,50) appartenant aux deux flancs amenées en contact avec la face arrière (51) de la paroi de fond (24) des traverses et troisièmement par les encoches dites premières (37,38) coopérant avec les parties formant nervures (45) des longerons inférieurs (11,12)..

13. Structure selon l'une quelconque des revendications 10 à 12, **caractérisée en ce que** le déplacement des traverses inférieures suivant la largeur de la structure est bloqué par d'une part, la mise en contact des deux rebords latéraux (27,28) de chaque traverse avec respectivement deux faces intérieures (56,57) appartenant respectivement aux deux longerons dits inférieurs et d'autre part par les encoches dites premières (37,38) coopérant avec les parties formant nervures (45) des longerons inférieurs (11,12).

14. Structure selon l'une quelconque des revendications 6 à 13, **caractérisée en ce que** les rebords longitudinaux dits seconds (26) sont fixés aux flancs (6,7), au niveau de chacune des extrémités des traverses, par l'intermédiaire de rivets.

15. Structure selon l'une quelconque des revendications 4 à 14, **caractérisée en ce qu'**elle est destinée à loger, entre les deux parties pleines (14,15) des flancs, une boîte à câbles (4), **en ce que** la partie située entre les deux parties comportant une ouverture (18,19) de forme sensiblement rectangulaire est destinée à permettre l'évacuation des gaz en cas d'arc interne, **en ce qu'**au-dessus de cette dernière partie est posée la partie principale 1 de l'appareil, et **en ce qu'**au-dessus de cette boîte à câbles se trouve un compartiment (5) destiné à loger la partie permettant la commande de l'appareil.
